# EUROPEAN PATENT APPLICATION

(11) **EP 3 527 687 A1**
(43) Date of publication of application: **21.08.2019**
(21) Application number: 18197055.9
(22) Date of filing: 27.09.2018
(51) Int. Cl.: C23C 14/06, C23C 14/34, C23C 14/58, H01L 31/0749, H01L 21/02, H01L 31/032

(54) **COPPER INDIUM GALLIUM SELENIDE ABSORPTION LAYER AND PREPARATION METHOD THEREOF, SOLAR CELL AND PREPARATION METHOD THEREOF**

(30) Priority: 08.02.2018 CN 201810128936
(71) Applicant: Beijing Apollo Ding Rong Solar Technology Co., Ltd., Beijing 100176 (CN)
(72) Inventor: Ye, Yakuan, Beijing, Beijing 100176 (CN); Zhao, Shuli, Beijing, Beijing 100176 (CN); Yang, Lihong, Beijing, Beijing 100176 (CN); Guo, Lida, Beijing, Beijing 100176 (CN)
(74) Representative: Cohausz & Florack

(57) **Abstract**

A preparation method of a copper indium gallium selenide (CIGS) absorption layer (100), including: forming a prefabricated copper indium gallium film on a substrate; placing the prefabricated copper indium gallium film in a reaction chamber having a first temperature threshold; introducing a selenium atmosphere having a first carrier gas flow value into the reaction chamber, such that the prefabricated copper indium gallium film reacts within a first duration to form an unsaturated In-Se binary phase and an unsaturated Cu-Se binary phase on a surface of the prefabricated copper indium gallium film; introducing a selenium atmosphere having a second carrier gas flow value into the reaction chamber, such that the prefabricated copper indium gallium film reacts within a second preset duration to obtain a prefabricated CIGS film; annealing the prefabricated CIGS film within a second preset temperature threshold and a third preset duration to obtain a solar cell absorption layer.

## Description

### CROSS-REFERENCE TO RELATED APPLICATION

This application claims priority to Chinese Patent Application No. 201810128936.0, submitted to the Chinese patent office on February 8, 2018, titled "PREPARETION METHOD OF SOLAR CELL ABSORPTION LAYER AND PREPARATION METHOD OF SOLAR CELL", which is incorporated herein by reference in its entirety.

### TECHNICAL FIELD

The present disclosure relates to a technical field of solar cell manufacturing, more particularly to a preparation method of a copper indium gallium selenide (CIGS) absorption layer and a preparation method of a solar cell.

### BACKGROUND

Thin-film CIGS solar cells are new-generation solar cells with promising prospects. They have the advantages of high conversion efficiency, low cost, long life, good low-light performance and strong radiation resistance. Since the 1990s, thin-film CIGS solar cells have always been thin-film solar cells with the highest conversion efficiency in laboratories. In 2016, ZSW from Germany increased the conversion efficiency of thin-film CIGS solar cells to 22.6% in the laboratory. Since the conversion efficiency of thin-film CIGS solar cells is close to the conversion efficiency of crystalline silicon cells, thin-film CIGS solar cells have great development prospects.

### SUMMARY

Some embodiments of the present disclosure provide a preparation method of CIGS absorption layer, comprising the following steps:
step 100: forming a copper gallium alloy layer and an indium layer sequentially on a substrate to obtain a prefabricated copper indium gallium film;
step 200: placing the prefabricated copper indium gallium film in a reaction chamber having a preset first temperature threshold; introducing a selenium atmosphere having a preset first carrier gas flow value into the reaction chamber; the prefabricated copper indium gallium film reacting in the selenium atmosphere of the first carrier gas flow value for a first preset duration, such that an unsaturated In-Se binary phase and an unsaturated Cu-Se binary phase are formed on a surface of the prefabricated copper indium gallium film.
step 300: introducing a selenium atmosphere having a preset second carrier gas flow value less than the preset first carrier gas flow value into the reaction chamber; the prefabricated copper indium gallium film having an unsaturated In-Se binary phase and an unsaturated Cu-Se binary phase formed on a surface thereof reacting in the selenium atmosphere having the second carrier gas flow value for a second preset duration, such that the selenium source contained in the selenium atmosphere diffuses toward the bottom of the prefabricated copper indium gallium film, and reacts with the copper indium gallium contained in the surface of the prefabricated copper indium gallium film adjacent to the substrate to obtain a CIGS prefabricated film formed on the surface of the substrate;
step 400: annealing the CIGS prefabricated film formed on the surface of the substrate within a preset second temperature threshold and a third preset duration to obtain a CIGS absorption layer.

In some embodiments, a back electrode is deposited on the substrate; the step 100 includes:
a copper gallium alloy layer and an indium layer are sequentially sputtered on the substrate on which the back electrode is deposited to obtain a prefabricated copper indium gallium film.

In some embodiments, a back electrode is deposited on the substrate; the step 100 includes:
a copper gallium alloy layer and an indium layer are sequentially sputtered on a surface of the back electrode of the substrate, such that the back electrode, the copper gallium alloy layer and the indium layer are laminated together to obtain a prefabricated copper indium gallium film.

In some embodiments, the prefabricated copper indium gallium film comprises Cu, In, and Ga, and the molar ratio of Cu, In, and Ga contained in the prefabricated copper indium gallium film satisfies: 0.8<n_{Cu}/(n_{In}+n_{Ga})<0.96 and 0.25 ≤n_{Ga}/(n_{In}+n_{Ga})≤ 0.35.

In some embodiments, the second carrier gas flow value is less than the first carrier gas flow value.

In some embodiments, the ratio of the first carrier gas flow value to the second carrier gas flow value is greater than five.

In some embodiments, the first carrier gas flow value is greater than or equal to 5 slm and less than or equal to 15 slm, and the second carrier gas flow value is greater than zero and less than or equal to 2 slm.

In some embodiments, before the step 200, the preparation method of CIGS absorption layer further comprises:
the solid selenium source is heated to a temperature within a preset third temperature threshold in a vacuum or an inert gas with set pressure to obtain a selenium atmosphere.

In some embodiments, the preset first temperature threshold is 550 °C ∼ 580 °C, the preset second temperature threshold is 500 °C ∼ 600 °C, the preset third temperature threshold is 250 °C ∼470 °C, and the set pressure is 1 Pa ∼ 1 atm.

In some specific embodiments, the first preset duration is 25 s to 35 s, the second preset duration is 260 s to 275 s, and the third preset duration is 5 min to 30 min.

In some embodiments, the preset first temperature threshold is 620 °C ∼ 700 °C, the preset second temperature threshold is 500 °C ∼ 600 °C, and the preset third temperature threshold is 380 °C ∼500 °C.

In some specific embodiments, the first preset duration is 15 s to 25 s, the second preset duration is 15 s to 35 s, and the third preset duration is 5 min to 30 min.

In some embodiments, a rate of temperature rise of the prefabricated copper indium gallium film during the reaction of steps 200 and 300 is greater than 3 °C / s.

In some embodiments, the reaction chamber is a graphite reaction chamber.

In some embodiments, the selenium atmosphere comprises: selenium vapor or hydrogen selenide gas.

In some embodiments, the annealing treatment is performed in a vacuum or in a selenium atmosphere having a preset third carrier gas flow value; when the annealing treatment is performed in a selenium atmosphere having a preset third carrier gas flow value, the preset third carrier gas flow value is less than a preset second carrier gas flow value.

Some embodiments of the present disclosure also provide a preparation method of a solar cell, comprising a preparation method of a copper indium selenium gallium absorption layer provided in some embodiments disclosed above.

Some embodiments of the present disclosure also provide a CIGS absorption layer prepared in the preparation method of the CIGS absorption layer.

Some embodiments of the present disclosure also provide a solar cell comprising the CIGS absorption layer.

### BRIEF DESCRIPTION OF THE DRAWINGS

The specific embodiments of the present disclosure will be further described in detail below with reference to the accompanying drawings.
FIG. 1 is a flow diagram of a preparation method of a CIGS absorption layer according to some embodiments of the present disclosure.
FIG. 2 is a flow diagram of a preparation method of a CIGS absorption layer according to some embodiments of the present disclosure.
FIG. 3 is a graph showing the distribution of EDS energy spectrum components of the CIGS absorption layer prepared in some embodiments of the present disclosure in the thickness direction of the CIGS absorption layer.
FIG. 4 is an X-ray diffraction spectrogram of a CIGS absorption layer prepared in a preparation method of the CIGS absorption layer according to some embodiments of the present disclosure.
FIG. 5 is a schematic diagram showing the structure of a solar cell according to some embodiments of the present disclosure.

### DETAILED DESCRIPTION

Embodiments of the present disclosure are described in detail below, and examples of the embodiments are illustrated in the accompanying drawings. The embodiments described below with reference to the accompanying drawings are exemplary, only for the purpose of interpreting the present disclosure, and shall not be construed as limiting the present disclosure.

In the related art, the preparation method of the CIGS absorption layer mainly includes a co-evaporation method, a post-sputter selenization method (abbreviated as a two-step selenization method), and an electrochemical method. When the CIGS absorption layer prepared in the electrochemical method is applied to a solar cell, the solar cell presents weaker stability and highest conversion efficiency than the solar cell that adopts a CIGS absorption layer prepared in the co-evaporation method and the two-step selenization method, as a result, the industrialization process of preparing a CIGS absorption layer in the electrochemical method is very slow.

The co-evaporation method refers to evaporating the four elements of Cu, In, Ga, and Se, simultaneously depositing the four elements on the substrate, and obtaining a CIGS absorption layer after reaction between the four elements. Small-area CIGS absorption layers prepared in the co-evaporation method are applied to solar cells, and the solar cells have high conversion efficiency, but the uniformity of the CIGS absorption layers prepared in the above co-evaporation method is difficult to control. As a result, the above co-evaporation method is difficult to be used in a preparation process of a large-area CIGS absorption layer, and industrial application of solar cells is somewhat limited, which makes solar cells hard to obtain high conversion efficiency.

The two-step selenization method is described as follows: firstly, sputtering In, Ga, and Cu on a surface of the substrate using target materials In₂Se₃, Ga₂Se₃, and Cu₂Se to obtain a CIGS prefabricated film, then subjecting the CIGS prefabricated film to high-temperature heat treatment in a H₂Se vapor atmosphere or a Se vapor atmosphere to obtain a CIGS absorption layer.

When the CIGS absorption layer is prepared by the above two-step selenization method, Se vapor with a saturated concentration is formed on the surface of the prefabricated copper indium gallium film, that is, the selenium atmosphere introduced into the reaction chamber causes the selenium vapor in the reaction chamber to be saturated. In the process of preparing a CIGS absorption layer in the two-step selenization method, the reaction enthalpy of Cu, In and Se is lower than that of Ga and Se, thereby the reaction rate of Cu, In and Se is faster. Therefore, Cu and In on the surface of the prefabricated copper indium gallium film can quickly and sufficiently react with the saturated selenium atmosphere, thereby obtaining relatively stable binary phases In₂Se₃ and Cu₂Se. Since the stable binary phases In₂Se₃ and Cu₂Se have relatively small lattice vacancies, element Se (element Se exists in the form of a selenium atmosphere) is prevented from diffusing toward the bottom of the prefabricated copper indium gallium film, resulting in a lower capability of element Se to diffuse to the bottom of the prefabricated copper indium gallium film. Cu and In at the bottom of the prefabricated copper indium gallium film also diffuse to the surface of the prefabricated copper indium gallium film earlier than Ga, and react with Se to form the binary phases In₂Se₃ and Cu₂Se. Based on the diffusion-impeding action produced by the binary phases In₂Se₃ and Cu₂Se on element Se, and the mechanism that Cu and In more preferentially fully react with Se, the bottom of the obtained CIGS absorption layer is enriched with fine grain Ga, causes element Ga to be unevenly distributed in the CIGS absorption layer, thereby greatly reducing the performance of the CIGS absorption layer.

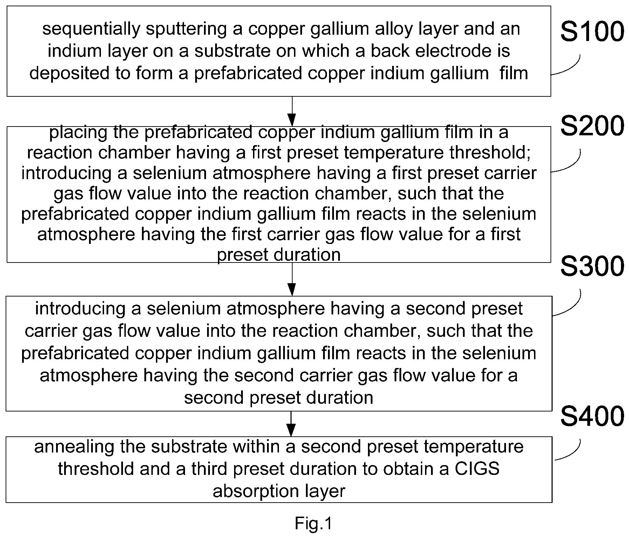

Regarding the above problems, as shown in Fig. 1, some embodiments of the present disclosure provide a preparation method of a CIGS absorption layer. The preparation method includes step 100 (S100), step 200 (S200), step 300 (S300), and step 400 (S400):
S100: forming a copper gallium alloy layer and an indium layer sequentially on the substrate to obtain a prefabricated copper indium gallium film;
S200: placing the prefabricated copper indium gallium film into a reaction chamber having a preset first temperature threshold; introducing a selenium atmosphere having a preset first carrier gas flow value into the reaction chamber; the prefabricated copper indium gallium film reacting in the selenium atmosphere having the first carrier gas flow value for a first preset duration, such that prefabricated copper indium gallium film an unsaturated In-Se binary phase and an unsaturated Cu-Se binary phase are formed on a surface of the prefabricated copper indium gallium film.

A graphite reaction chamber can be selected. The graphite reaction chamber has good adiabaticity and chemical stability under high temperature conditions. The graphite reaction chamber reacts with oxygen at a high temperature to form a reducing atmosphere, so that metal in the reaction chamber is not oxidized. Of course, the reaction chamber can also be other reaction chambers, which will not be enumerated here.

S300: introducing a selenium atmosphere having a preset second carrier gas flow value into the reaction chamber, wherein the prefabricated copper indium gallium film having an unsaturated In-Se binary phase and an unsaturated Cu-Se binary phase formed on a surface thereof reacts for a second preset duration in a selenium atmosphere having the second carrier gas flow value, such that the selenium source contained in the selenium atmosphere diffuses toward the bottom of the prefabricated copper indium gallium film, and reacts with the copper indium gallium contained in the prefabricated copper indium gallium film to obtain a CIGS prefabricated film formed on the surface of the substrate;

S400: annealing the CIGS prefabricated film formed on the surface of the substrate within a preset second temperature threshold and a third preset duration to obtain a CIGS absorption layer.

In the above embodiment of the present disclosure, after the prepared prefabricated copper indium gallium film is placed in the reaction chamber, a selenium atmosphere having a first carrier gas flow value is introduced into the reaction chamber, so that the selenium atmosphere in the reaction chamber is at a high concentration. When the prefabricated copper indium gallium film is maintained in the selenium atmosphere for a first preset duration, such that the prefabricated copper indium gallium film is at a high concentration of Se, prefabricated copper indium gallium film the In-Se binary phase and the Cu-Se binary phase with unsaturated chemical bonds are formed on the surface of the prefabricated copper indium gallium film. Since the first preset duration is short, the unsaturated In-Se binary phase and the unsaturated Cu-Se binary phase have no time to undergo a selenization reaction with the selenium source in the first preset duration to generate a saturated In₂Se₃ binary phase and a saturated Cu₂Se binary phase. Thereafter, a selenium atmosphere having a second carrier gas flow value is introduced into the reaction chamber, such that the prefabricated copper indium gallium film having an unsaturated In-Se binary phase and an unsaturated Cu-Se binary phase formed on the surface continues to react with the selenium source in a selenium atmosphere with a low flow rate, thereby the selenium source contained in a selenium atmosphere diffuses toward the bottom of the prefabricated copper indium gallium film, and reacts with the copper indium gallium contained in the prefabricated copper indium gallium film prefabricated copper indium gallium film to obtain a CIGS prefabricated film formed on the surface of the substrate, so as to ensure that the selenium element contained in the prepared CIGS prefabricated film is uniformly distributed in the thickness direction of the CIGS prefabricated film.

Exemplarily, when the second carrier gas flow value is less than the first carrier gas flow value, the prefabricated copper indium gallium film having the unsaturated In-Se binary phase and the unsaturated Cu-Se binary phase formed on a surface thereof continues to react with the selenium source in a selenium atmosphere with a low flow rate, and the selenization reaction proceeds to the second process. Since the flow rate of the selenium atmosphere introducing into the reaction chamber in the second process is lowered, the concentration of Se of the unsaturated In-Se binary phase and the unsaturated Cu-Se binary phase on the surface of the prefabricated copper indium gallium film is lowered, and the low flow rate of the selenium atmosphere is not enough to provide a Se source with sufficient concentration for the unsaturated In-Se binary phase and the unsaturated Cu-Se binary phase on the surface of the prefabricated copper indium gallium film to be further selenized. On the other hand, partial chemical bonds of the In-Se binary phase and the Cu-Se binary phase are not saturated, and from the angle of lattice, the In-Se binary phase and Cu-Se binary phase have large lattice vacancies; therefore, the above-described In-Se binary phase and Cu-Se binary phase do not hinder the selenium source from diffusing toward the bottom of the prefabricated copper indium gallium film in the form of a selenium atmosphere. In other words, the selenium atmosphere in the reaction chamber is maintained at a low concentration when a selenium atmosphere having a preset low flow rate (second carrier gas flow value) is introduced into the reaction chamber, which makes the prefabricated copper indium gallium film maintained in a low-concentration selenium atmosphere for a second preset duration. Therefore, the selenium source diffuses toward the bottom of the prefabricated copper indium gallium film in the form of selenium vapor through the lattice vacancies of the above In-Se binary phase and the Cu-Se binary phase prefabricated copper indium gallium film, such that Se reacts with Cu, In and Ga at the bottom of the prefabricated copper indium gallium film to form an alloy phase. This avoids the problem that element Ga in the prepared CIGS absorption layer is enriched at the bottom, and ensures that element Ga in the prepared CIGS absorption layer is evenly distributed, and a grain size of element Ga is increased.

The main purpose of the above annealing treatment is to release stress, increase material ductility and toughness, and produce a special microstructure. The preparation method of the CIGS absorption layer provided in some embodiments of the present disclosure is to anneal the CIGS prefabricated film obtained from the selenization reaction under a condition of a small amount of selenium atmosphere. The final CIGS absorption layer obtained from the annealing treatment not only has a large grain size, but also presents uniform distribution of element Ga, which can solve problems hard to control in related technologies such as stability of large-area solar cells and processing uniformity.

In some embodiments, the substrate 10 is made of soda lime glass having a thickness of 2 mm to 3.2 mm. A back electrode is deposited on the surface of the substrate 10. A copper gallium alloy layer and an indium layer are sequentially formed on the substrate 10.

In some embodiments, the back electrode is a metal molybdenum layer formed of metal molybdenum. The metal molybdenum layer has a thickness of 300 nm to 1,000 nm.

In some embodiments, when the back electrode is deposited on the substrate, the above S100 includes:
A copper gallium alloy layer and an indium layer are sequentially sputtered on the surface of the back electrode of the substrate, such that the back electrode, the copper gallium alloy layer and the indium layer are laminated together to obtain a prefabricated copper indium gallium film. The sputtering method is a magnetron sputtering method. The magnetron sputtering method is a DC magnetron sputtering method or an intermediate frequency magnetron sputtering method.

In some embodiments, the copper gallium alloy layer has a thickness of 250 nm ∼ 400 nm. The thickness of the indium layer is 200 ∼ 300 nm. The prefabricated copper indium gallium film formed of the copper gallium alloy layer and the indium layer includes three elements Cu, In and Ga. The molar ratio of Cu, In, and Ga contained in the prefabricated copper indium gallium film satisfies: 0.8 < n_{Cu}/(n_{In}+n_{Ga}) < 0.96 and 0.25 ≤n_{Ga}/(n_{In}+n_{Ga}) ≤ 0.35.

For example, the thickness of the above copper gallium alloy layer is 300 nm. The thickness of the indium layer is 250 nm. The molar percentage of copper atoms in the copper gallium alloy layer is 75%, and the molar percentage of gallium atoms in the copper gallium alloy layer is 25%. At this time, the molar ratio of Cu, In, and Ga contained in the prefabricated copper indium gallium film satisfies: 0.8 < n_{Cu}/(n_{In}+n_{Ga})< 0.96 and 0.25 ≤n_{Ga}/(n_{In}+n_{Ga})≤ 0.35.

When n_{Cu}/(n_{In}+n_{Ga})=0.96, the above prefabricated copper indium gallium film reacts with the selenium atmosphere, which is easy to form a Cu-rich CuₓSe phase (x>1). Since the chemical saturation of the CuₓSe phase is high and the lattice vacancy between adjacent crystal phases is small, the CuₓSe phase hinders the selenium source from diffusing toward the bottom of the prefabricated copper indium gallium film in the form of a selenium atmosphere. Compared with copper, indium and gallium, selenium has weaker selenization ability in a low-concentration Se atmosphere. Thereby fine grains of element Ga are easily enriched at the bottom of the CIGS absorption layer, resulting in a significant decrease of performance of the CIGS absorption layer. Therefore, when the prepared CIGS absorption layer is applied to a solar cell, a high-performance solar cell is not available.

When n_{Cu}/(n_{In}+n_{Ga})=0.80, the formed CIGS absorption layer contains a large number of In-Se binary phases and Ga-Se binary phases. When the In-Se binary phase and the Ga-Se binary phase contained in the CIGS absorption layer are large, a CIGS quaternary phase of a chalcopyrite structure cannot be formed in the CIGS absorption layer. As a result, when the CIGS absorption layer is applied to a solar cell, the performance of the solar cell is reduced.

In some embodiments, the first carrier gas flow value is greater than the second carrier gas flow value. When the first carrier gas flow value is greater than the second carrier gas flow value, the concentration of the selenium atmosphere in the reaction chamber during the reaction period of the first preset duration is greater than the concentration during the reaction period of the second preset duration. Therefore, in the process when the prefabricated copper indium gallium film reacts in the selenium atmosphere having the first carrier gas flow value for the first preset duration, the prefabricated copper indium gallium film reacts rapidly with a high-concentration selenium atmosphere to form an In-Se binary phase and a Cu-Se binary phase on the surface of the prefabricated copper indium gallium film. However, because the first preset duration is short, the In-Se binary phase and the Cu-Se binary phase have no time for further selenization to form the In₂Se₃ binary phase and the Cu₂Se binary phase, and the amount of selenium atmosphere introduced to the reaction chamber is reduced from the first carrier gas flow value to the second carrier gas flow value. The prefabricated copper indium gallium film having the In-Se binary phase and the Cu-Se binary phase formed on a surface thereof has a low concentration of selenium atmosphere. This not only prevents the In-Se binary phase and the Cu-Se binary phase formed on the surface of the prefabricated copper indium gallium film from rapidly forming a saturated In₂Se₃ binary phase and a saturated Cu₂Se binary phase, but also complements the selenium source required for forming a CIGS quaternary phase in the reaction of the prefabricated copper indium gallium film having the in-Se binary phase and the Cu-Se binary phase formed on a surface thereof. The above element Se diffuses, in the form of a selenium atmosphere, to the bottom of the prefabricated copper indium gallium film having a surface on which the In-Se binary phase and the Cu-Se binary phase are formed, thereby ensuring that element Ga contained in the prepared CIGS absorption layer is uniformly distributed.

In some embodiments, the ratio of the first carrier gas flow value to the second carrier gas flow value is greater than five. The unit of carrier gas flow value is slm, which is the abbreviation of standard litre per minute. It refers to the carrier gas flow value of 1L/min in a standard state (1 atmosphere, 25 degrees Celsius), and the unit of all the following carrier gas flow values is expressed by slm.

Exemplarily, when the first carrier gas flow value is greater than or equal to 5 slm and less than or equal to 15 slm, the concentration of the selenium atmosphere of the reaction chamber at the first carrier gas flow value is high, and the prefabricated copper indium gallium film reacts in the high-concentration selenium atmosphere for a first preset duration. Since the first preset duration is short, prefabricated copper indium gallium filman unsaturated In-Se binary phase and an unsaturated Cu-Se binary phase are formed on the surface of the prefabricated copper indium gallium film. When the second carrier gas flow value is greater than 0 and less than or equal to 2 slm, the concentration of the selenium atmosphere of the reaction chamber at the second carrier gas flow value is low, so that the Se atoms are rapidly diffused to the bottom of the prefabricated copper indium gallium film through the lattice vacancies of the unsaturated In-Se binary phase and the unsaturated Cu-Se binary phase, and react with Cu, In and Ga at the bottom of the prefabricated copper indium gallium film, thereby avoiding the phenomenon that element Ga is enriched at the bottom of the CIGS absorption layer.

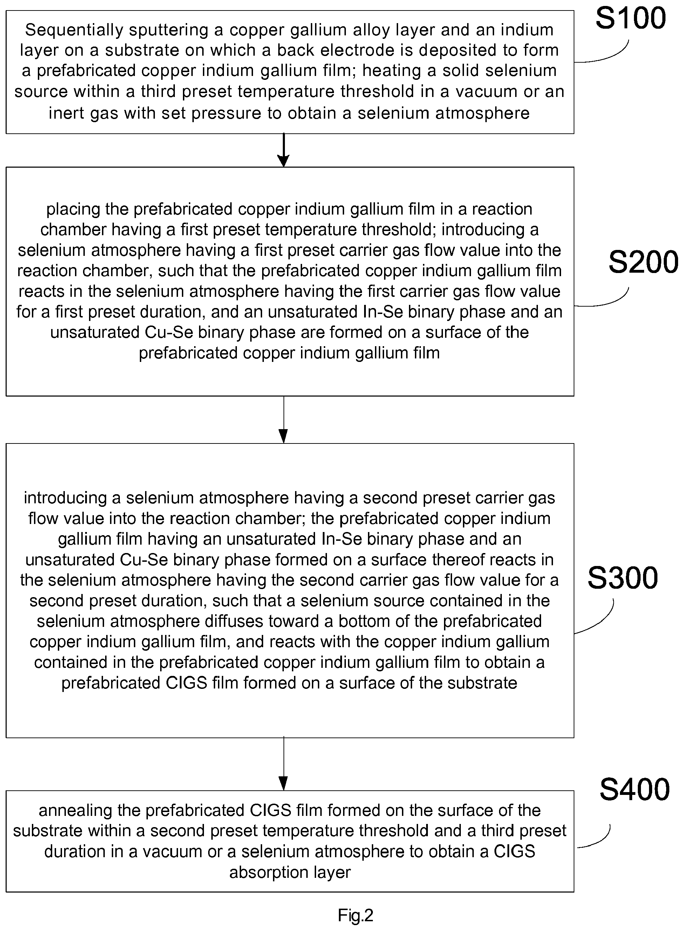

In some embodiments, the selenium atmosphere described above is a selenium vapor or a hydrogen selenide (H₂Se) gas, but it is of course not limited to the two listed above. In some embodiments, as shown in FIG. 2, before the S200, the preparation method of the CIGS absorption layer further includes:

in a vacuum or an inert gas with set pressure, the solid selenium source is heated to a third preset temperature threshold to obtain a selenium atmosphere, which facilitates subsequent flow control of carrier gas of the selenium atmosphere introduced into the reaction chamber. The inert gas can be nitrogen or argon. When the solid selenium source is selenium of a single element, the selenium atmosphere is selenium vapor. The selenium atmosphere at the first carrier gas flow value and the selenium atmosphere at the second carrier gas flow value are obtained by heating the solid selenium source to a third preset temperature threshold in a vacuum or an inert gas with set pressure. Therefore, the selenium atmosphere at the first carrier gas flow value and the selenium atmosphere at the second carrier gas flow value are only different in the flow rate of selenium atmosphere.

In some embodiments, the above-described prefabricated copper indium gallium film has an average temperature rising rate of greater than 3 °C/s in the reaction chamber. In the reaction period of the first preset duration, the temperature rising rate is high, about 15 °C / s -20 °C / s, and in the reaction period of the second preset duration, the temperature rising rate is low. The average temperature rising rate of the copper-indium gallium prefabricated film at the first preset duration and the second preset duration is controlled at a high level, e.g. above 3 °C / s, such that the selenium atmosphere is maintained at a high diffusion and reaction rate. The temperature rising rate of the above prefabricated copper indium gallium film in the reaction chamber depends on two factors, one of which is the temperature of the reaction chamber itself. The reaction chamber plays the role of radiation and heat transfer to the prefabricated copper indium gallium film. The second is the temperature of the selenium atmosphere, and the selenium atmosphere transfers heat to the prefabricated copper indium gallium film by convection.

In some embodiments, the first preset temperature threshold is 550 °C ∼ 580 °C. In the range of 550 °C ∼ 580 °C, the prefabricated copper indium gallium film fully reacts with the selenium atmosphere to obtain a high-performance CIGS absorption layer with element Ga well distributed. The third preset temperature threshold is 250 °C ∼ 470 °C, which ensures formation of a high-temperature selenium atmosphere, and facilitates subsequent reaction of the selenium atmosphere with the prefabricated copper indium gallium film. The above set pressure is 1 Pa to 1 atm.

The first preset duration is 25s to 35s, and prefabricated copper indium gallium filman unsaturated In-Se binary phase and an unsaturated Cu-Se binary phase are formed on the surface of the prefabricated copper indium gallium film in a relatively short period. For example, the first preset duration is 30s.

The second preset duration is 260s∼275s, and in the reaction period of the second preset duration, a selenium atmosphere having a second carrier gas flow rate is introduced into the reaction chamber, the prefabricated copper indium gallium film having the unsaturated In-Se binary phase and the unsaturated Cu-Se binary phase formed on a surface thereof is in a low-concentration selenium atmosphere for a relatively long period. Since the unsaturated In-Se binary phase and the unsaturated Cu-Se binary phase on the surface of the prefabricated copper indium gallium film have large lattice vacancies, element Se diffuses toward the bottom of the prefabricated copper indium gallium film, thereby avoiding the phenomenon that element Ga is enriched at the bottom of the CIGS absorption layer. A selenium atmosphere is introduced into the reaction chamber at a second carrier gas flow rate within a second preset duration of 260 s to 275 s, which complements the selenium source required to form a CIGS quaternary phase upon reaction with the prefabricated copper indium gallium film containing the unsaturated In-Se binary phase and the unsaturated Cu-Se binary phase. Based on this, a uniform CIGS film layer is formed. For example, in the embodiment, the second preset duration is preferably 270 s.

The preset second temperature threshold is 500 °C ∼ 600 °C, and the third preset duration is 5 min ∼ 30 min, so that a sufficient high-temperature annealing treatment is implemented on the prefabricated copper indium gallium film.

In this embodiment, the temperature rising rate of the prefabricated copper indium gallium film in the reaction chamber is greater than 3 °C / s and less than or equal to 6 °C / s. Under this temperature rising rate, the Se source in the selenium atmosphere maintains a high diffusion rate between the surface and the bottom of the prefabricated copper indium gallium film, and the flow rate of the selenium atmosphere is matched with the temperature rising rate of the reaction chamber. On this basis, the reaction rate of the prefabricated copper indium gallium film with the selenium source contained in the selenium atmosphere is controlled.

In addition, from the first preset duration and the second preset duration disclosed in the above embodiment, it can be seen that in the method for manufacturing a CIGS absorption layer in the above embodiment, the operating window of process parameters is very large, which is beneficial to process parameter control.

In some other embodiments, the first preset temperature threshold may be 620 °C ∼ 700 °C. The range 620 °C ∼ 700 °C ensures that the prefabricated copper indium gallium film and the selenium atmosphere fully react, so as to obtain a high-performance CIGS absorption layer with element Ga well distributed. The preset second temperature threshold is 500 °C ∼ 600 °C. The preset third temperature threshold is 380 °C ∼ 500 °C to form a high-temperature selenium atmosphere. The heat contained in the selenium atmosphere is used to supplement the heat required for the reaction between the prefabricated copper indium gallium film and the selenium source contained in the selenium atmosphere, so that the high-temperature selenium atmosphere can sufficiently react with the prefabricated copper indium gallium film.

The first preset duration is 15s∼25s. The second preset duration is 15s∼35s. When the first preset duration is 15s∼25s and the second preset duration is 15s∼35s, under the condition of a high reaction temperature, it is beneficial to shorten the reaction time of the prefabricated copper indium gallium film and the selenium atmosphere, so as to improve the reaction efficiency of the prefabricated copper indium gallium film and the selenium source contained in the selenium atmosphere.

As can be seen from the above, the second preset duration is longer than the first preset duration, such that an unsaturated In-Se binary phase and an unsaturated Cu-Se binary phase are formed on the surface of the prefabricated copper indium gallium film in a short period of time (first preset duration), and element Se diffuses toward the bottom of the prefabricated copper indium gallium film in a long period of time (second preset duration), thereby avoiding the problem that element Ga is enriched at the bottom of the prepared CIGS absorption layer. At the same time, since the second preset duration is longer than the first preset duration, the selenium source required to produce a CIGS quaternary phase in the reaction of the prefabricated copper indium gallium film is complemented in a long period of time (second preset duration).

In this embodiment, the temperature rising rate of the prefabricated copper indium gallium film in the reaction chamber is greater than 6 °C / s. When the temperature rising rate of the prefabricated copper indium gallium film in the reaction chamber is greater than 6 °C / s, at the temperature rising rate of the reaction chamber, the temperature rising rate of the prefabricated copper indium gallium film in the reaction chamber is relatively fast, such that the selenium source diffuses toward the bottom of the prefabricated copper indium gallium film in a fast speed. Therefore, element Ga in the CIGS absorption layer prepared in the preparation method of the CIGS absorption layer according to the above embodiments presents a trend of uniform distribution, which ensures a high performance of the prepared CIGS absorption layer.

In some embodiments, in order to improve the diffusion rate of the selenium element in the prefabricated copper indium gallium film, so as to obtain a high-performance CIGS absorption layer, the second temperature threshold is 580 °C, and the third preset duration is 5 min∼30 min.

In some embodiments, the annealing treatment is performed in a vacuum or in a selenium atmosphere having a third preset carrier gas flow value. When the annealing process is performed in a selenium atmosphere having a third preset carrier gas flow value, the third preset carrier gas flow value is less than a second preset carrier gas flow value, thereby the degree of reaction between the copper indium gallium contained in the CIGS prefabricated film and the selenium source contained in the selenium atmosphere is further improved. The preparation method of the CIGS absorption layer provided in the embodiment of the present disclosure will be described in detail below with reference to the embodiments.

### Example 1

The preparation method of the CIGS absorption layer provided in the embodiment includes the following steps:
S100: sequentially sputtering a copper gallium alloy layer and an indium layer on the substrate on which a back electrode is deposited to obtain a 700 nm prefabricated copper indium gallium film.

In S100, a copper gallium alloy layer and an indium layer are sequentially formed on the surface of the back electrode of the substrate. The sputtering method is a DC magnetron sputtering method. The substrate is made of soda lime glass having a thickness of 2mm. The back electrode is a metal molybdenum layer formed of metal molybdenum. The metal molybdenum layer has a thickness of 700 nm. The molar ratios of Cu, In, and Ga contained in the prefabricated copper indium gallium film satisfies: n_{Cu}/(n_{In}+n_{Ga})=0.82 and n_{Ga}/(n_{In}+n_{Ga})=0.25.

Protected by nitrogen, the single element selenium is heated to 250 °C under a pressure of 1 Pa to obtain selenium vapor.

S200: Placing the prefabricated copper indium gallium film in a reaction chamber at 550 °C (the temperature rising rate of the reaction chamber is 4 °C / s); introducing 5 slm of selenium vapor into the reaction chamber. The prefabricated copper indium gallium film reacts in the 5 slm of selenium vapor for 35 s, so that an In-Se binary phase and a Cu-Se binary phase are formed on the surface of the prefabricated copper indium gallium film.

S300: Introducing 1 slm of selenium vapor into the reaction chamber. The prefabricated copper indium gallium film having the In-Se binary phase and the Cu-Se binary phase formed on a surface thereof reacts for 275 s in 1 slm of selenium vapor, so that Se contained in the selenium vapor diffuses toward the bottom of the prefabricated copper indium gallium film and reacts with the copper indium gallium contained in the prefabricated copper indium gallium film to obtain a CIGS prefabricated film formed on the surface of the substrate.

S400: Annealing the CIGS prefabricated film formed on the surface of the substrate in a vacuum environment at a temperature of 500 °C for 30 min to obtain a CIGS absorption layer.

### Example 2

The preparation method of the CIGS absorption layer provided in the embodiment includes the following steps:
S100: sequentially sputtering a copper gallium alloy layer and an indium layer on the substrate on which a back electrode is deposited to obtain a prefabricated copper indium gallium film.

In S100, a copper gallium alloy layer and an indium layer are sequentially formed on the surface of the back electrode of the substrate. The sputtering method is an intermediate frequency magnetron sputtering method. The substrate is made of soda lime glass having a thickness of 3 mm. The back electrode is a metal molybdenum layer formed of metal molybdenum. The metal molybdenum layer has a thickness of 1,000 nm. The molar ratios of Cu, In, and Ga contained in the prefabricated copper indium gallium film satisfy: n_{Cu}/(n_{In}+n_{Ga})=0.92 and r_{Ga}/(n_{In}+n_{Ga})=0.3.

The single element selenium is heated to 400 °C in a vacuum to obtain selenium vapor.

S200: Placing the prefabricated copper indium gallium film in a reaction chamber at 580 °C (the temperature rising rate of the reaction chamber is 5 °C / s); introducing 10 slm of selenium vapor into the reaction chamber. The prefabricated copper indium gallium film reacts in the 10 slm of selenium vapor for 35 s, so that an In-Se binary phase and a Cu-Se binary phase are formed on the surface of the prefabricated copper indium gallium film.

S300: Introducing 2 slm of selenium vapor into the reaction chamber. The prefabricated copper indium gallium film having the In-Se binary phase and the Cu-Se binary phase formed on a surface thereof reacts in the 2slm of selenium vapor for 260s, so that Se contained in the selenium vapor diffuses toward the bottom of the prefabricated copper indium gallium film, and reacts with the copper indium gallium contained in the prefabricated copper indium gallium film to obtain a CIGS prefabricated film formed on the surface of the substrate.

S400: Annealing the CIGS prefabricated film formed on the surface of the substrate at a temperature of 600 °C for 5 min in a flow rate of 0.5 slm of selenium vapor to obtain a CIGS absorption layer.

### Example 3

The preparation method of the CIGS absorption layer provided in the embodiment includes the following steps:
S100, sequentially sputtering a copper gallium alloy layer and an indium layer on the substrate on which a back electrode is deposited to obtain a prefabricated copper indium gallium film. At this time, the copper gallium alloy layer and the indium layer are sequentially formed on the surface of the back electrode of the substrate. The sputtering method is an intermediate frequency magnetron sputtering method. The substrate is made of soda lime glass having a thickness of 2.5 mm. The back electrode is a metal molybdenum layer formed of metal molybdenum. The metal molybdenum layer has a thickness of 300 nm. The molar values of Cu, In, and Ga contained in the prefabricated copper indium gallium film satisfy: n_{Cu}/(n_{In}+n_{Ga})=0.9 and n_{Ga}/(n_{In}+n_{Ga})=0.36.

Protected by argon, the single element selenium is heated to 380 °C under a pressure of 0.8 Pa to obtain selenium vapor.

S200: Placing the prefabricated copper indium gallium film in a reaction chamber at 550 °C (the temperature rising rate of the reaction chamber is 6 °C / s); introducing 15 slm of selenium vapor into the reaction chamber. The prefabricated copper indium gallium film reacts in the 15 slm of selenium vapor for 30 s, so that an In-Se binary phase and a Cu-Se binary phase are formed on the surface of the prefabricated copper indium gallium film.

S300: Introducing 1.5 slm of selenium vapor into the reaction chamber. The prefabricated copper indium gallium film having the In-Se binary phase and the Cu-Se binary phase formed on a surface thereof reacts for 265 s in the 1.5 slm of selenium vapor, so that Se contained in the selenium vapor diffuses toward the bottom of the prefabricated copper indium gallium film and reacts with the copper indium gallium contained in the prefabricated copper indium gallium film to obtain a CIGS prefabricated film formed on the surface of the substrate.

S400: Annealing the CIGS prefabricated film formed on the surface of the substrate in a vacuum at a temperature of 540 °C for 18 min to obtain a CIGS absorption layer.

### Example 4

The preparation method of the CIGS absorption layer provided in the embodiment includes the following steps:

S100: sequentially sputtering a copper gallium alloy layer and an indium layer on the substrate on which a back electrode is deposited to obtain a prefabricated copper indium gallium film.

In S100, the copper gallium alloy layer and the indium layer are sequentially formed on the surface of the back electrode of the substrate. The sputtering method is a DC magnetron sputtering method. The substrate is made of soda lime glass having a thickness of 2.5 mm. The back electrode is a metal molybdenum layer formed of metal molybdenum. The metal molybdenum layer has a thickness of 500 nm. The atomic ratios of Cu, In, and Ga contained in the prefabricated copper indium gallium film satisfy: n_{Cu}/(n_{In}+n_{Ga})=0.9 and n_{Ga}/(n_{In}+n_{Ga})=0.36.

Protected by argon, the single element selenium is heated to 470 °C under a pressure of 0.8 Pa to obtain selenium vapor.

S200: Placing the prefabricated copper indium gallium film in a reaction chamber at 620 °C (the temperature rising rate of the reaction chamber is 8°C / s); Introducing 15 slm of selenium vapor into the reaction chamber. The prefabricated copper indium gallium film reacts in the 7 slm of selenium vapor for 25 s, so that an In-Se binary phase and a Cu-Se binary phase are formed on the surface of the prefabricated copper indium gallium film.

S300: Introducing 1.2 slm of selenium vapor into the reaction chamber. The prefabricated copper indium gallium film having the In-Se binary phase and the Cu-Se binary phase formed on a surface thereof reacts for 35 s in the 1.2 slm of selenium vapor, so that Se contained in the selenium vapor diffuses toward the bottom of the prefabricated copper indium gallium film and reacts with the copper indium gallium contained in the prefabricated copper indium gallium film to obtain a CIGS prefabricated film formed on the surface of the substrate.

S400: Annealing the CIGS prefabricated film formed on the surface of the substrate in a flow rate of 0.5slm of selenium vapor at a temperature of 580 °C for 24 min to obtain a CIGS absorption layer.

### Example 5

The preparation method of the CIGS absorption layer provided in the embodiment includes the following steps:

S100: sequentially sputtering a copper gallium alloy layer and an indium layer on the substrate on which a back electrode is deposited to obtain a prefabricated copper indium gallium film.

In S100, the copper gallium alloy layer and the indium layer are sequentially formed on the surface of the back electrode of the substrate. The sputtering method is a DC magnetron sputtering method. The substrate10 is made of soda lime glass having a thickness of 3.2 mm. The back electrode is a metal molybdenum layer formed of metal molybdenum. The metal molybdenum layer has a thickness of 500 nm. The atomic ratios of Cu, In, and Ga contained in the prefabricated copper indium gallium film satisfy: n_{Cu}/(n_{In}+n_{Ga})=0.82 and n_{Ga}/(n_{In}+n_{Ga})=0.3.

Protected by argon, the single element selenium is heated to 500 °C under a pressure of 0.4 Pa to obtain selenium vapor.

S200: Placing the prefabricated copper indium gallium film in a reaction chamber at 640 °C (the temperature rising rate of the reaction chamber is 7°C/s); introducing 10 slm of selenium vapor into the reaction chamber. The prefabricated copper indium gallium film reacts in the 10 slm of selenium vapor for 15 s, so that an In-Se binary phase and a Cu-Se binary phase are formed on the surface of the prefabricated copper indium gallium film.

S300: Introducing 1 slm of selenium vapor into the reaction chamber. The prefabricated copper indium gallium film having the In-Se binary phase and the Cu-Se binary phase formed on a surface thereof reacts for 25 s in the 1 slm of selenium vapor, so that Se contained in the selenium vapor diffuses toward the bottom of the prefabricated copper indium gallium film and reacts with the copper indium gallium contained in the prefabricated copper indium gallium film to obtain a CIGS prefabricated film formed on the surface of the substrate.

S400: Annealing the CIGS prefabricated film formed on the surface of the substrate at a temperature of 580 °C for 24 min in a flow rate of 0.2 slm of selenium vapor to obtain a CIGS absorption layer.

### Example 6

The preparation method of the CIGS absorption layer provided in the embodiment includes the following steps:

S100: sequentially sputtering a copper gallium alloy layer and an indium layer on the substrate on which a back electrode is deposited to obtain a 300 nm prefabricated copper indium gallium film.

In S100, the copper gallium alloy layer and the indium layer are sequentially formed on the surface of the back electrode of the substrate. The sputtering method is a DC magnetron sputtering method. The substrate is made of soda lime glass having a thickness of 2 mm. The back electrode is a metal molybdenum layer formed of metal molybdenum. The metal molybdenum layer has a thickness of 300 nm. The atomic ratios of Cu, In, and Ga contained in the prefabricated copper indium gallium film satisfy: n_{Cu}/(n_{In}+n_{Ga})=0.92 and n_{Ga}/(n_{In}+n_{Ga})=0.3.

S200: Placing the prefabricated copper indium gallium film in a reaction chamber at 640 °C (the temperature rising rate of the reaction chamber is 10°C / s); introducing 12 slm of hydrogen selenide gas into the reaction chamber. The prefabricated copper indium gallium film reacts in the 12 slm of hydrogen selenide gas for 15 s, so that an In-Se binary phase and a Cu-Se binary phase are formed on the surface of the prefabricated copper indium gallium film.

S300: Introducing 1 slm of hydrogen selenide gas into the reaction chamber. The prefabricated copper indium gallium film having the In-Se binary phase and the Cu-Se binary phase formed on a surface thereof reacts for 35 s in the 1 slm of hydrogen selenide gas, so that hydrogen selenide contained in the hydrogen selenide gas diffuses toward the bottom of the prefabricated copper indium gallium film and reacts with the copper indium gallium contained in the prefabricated copper indium gallium film to obtain a CIGS prefabricated film formed on the surface of the substrate.

S400: Annealing the CIGS prefabricated film at a temperature of 500 °C for 30 min in a vacuum to obtain a CIGS absorption layer.

### Example 7

The preparation method of the CIGS absorption layer provided in the embodiment includes the following steps:
S100: sequentially sputtering a copper gallium alloy layer and an indium layer on the substrate on which a back electrode is deposited to obtain a 800 nm prefabricated copper indium gallium film.

In S100, the copper gallium alloy layer and the indium layer are sequentially formed on the surface of the back electrode of the substrate. The sputtering method is a DC magnetron sputtering method. The substrate is made of soda lime glass having a thickness of 3.2 mm. The back electrode is a metal molybdenum layer formed of metal molybdenum. The metal molybdenum layer has a thickness of 800 nm. The atomic values of Cu, In, and Ga contained in the prefabricated copper indium gallium film satisfy: n_{Cu}/(n_{In}+n_{Ga})=0.90 and n_{Ga}/(n_{In}+n_{Ga})=0.25.

S200: Placing the prefabricated copper indium gallium film in a reaction chamber at 650 °C (the temperature rising rate of the reaction chamber is 9°C / s); introducing 5 slm of selenium vapor into the reaction chamber. The prefabricated copper indium gallium film reacts in the 5 slm of selenium vapor for 18 s, so that an In-Se binary phase and a Cu-Se binary phase are formed on the surface of the prefabricated copper indium gallium film.

S300: Introducing 1 slm of hydrogen selenide gas into the reaction chamber. The prefabricated copper indium gallium film having the In-Se binary phase and the Cu-Se binary phase formed on the surface reacts for 15 s in the 1 slm of hydrogen selenide gas, so that hydrogen selenide contained in the hydrogen selenide gas diffuses toward the bottom of the prefabricated copper indium gallium film and reacts with the copper indium gallium contained in the prefabricated copper indium gallium film to obtain a CIGS prefabricated film formed on the surface of the substrate.

S400: Annealing the CIGS prefabricated film at a temperature of 600 °C for 5 min in a hydrogen selenide environment to obtain a CIGS absorption layer.

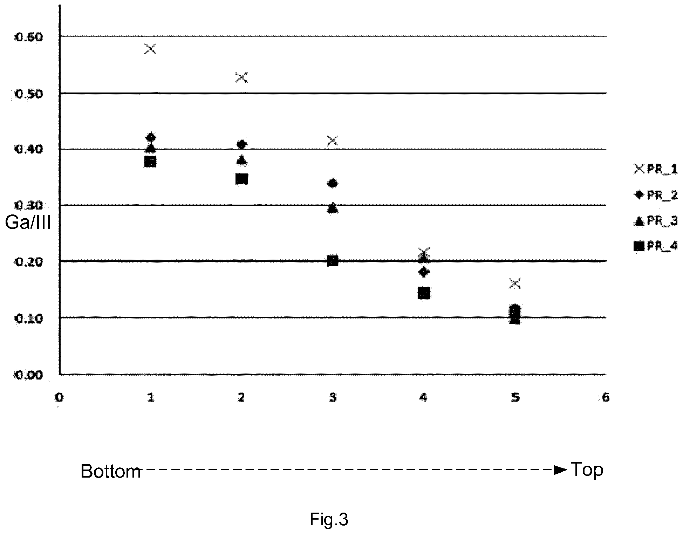

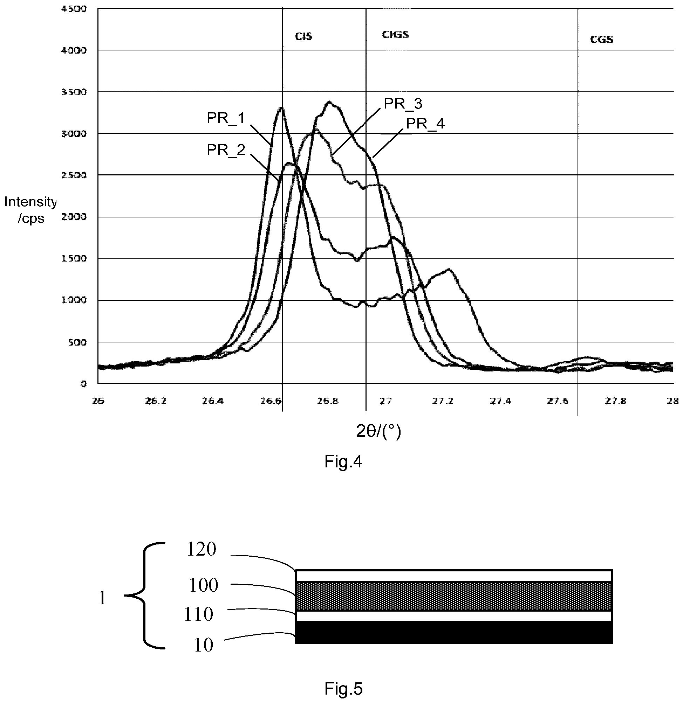

FIG. 3 is a diagram for analyzing the distribution of EDS energy spectrum components of Ga(III) in the thickness direction of the CIGS absorption layer. FIG.4 shows an X-ray diffraction pattern of a CIGS absorption layer prepared in a preparation method of a CIGS absorption layer. PR_1 in Fig. 3 and Fig. 4 is a CIGS absorption layer prepared in a two-step selenization method, and PR_2-PR_4 are CIGS absorption layers prepared respectively in the preparation methods described in the above Examples 1-3.

As can be seen from Fig. 3, the distribution gradient of Ga(III) contained in the CIGS absorption layer represented by the above PR1-PR4 from a surface to a bottom of the prefabricated film in the thickness direction is gradually decreased. Therefore, the preparation method of the CIGS absorption layer provided in the embodiments of the present disclosure effectively alleviates the problem that Ga(III) is enriched at the bottom of the CIGS absorption layer.

As can be seen from Fig. 4, the CIGS absorption layer represented by the above PR1 is a CIGS absorption layer in which a copper indium selenide phase is separated from a CIGS phase. The CIGS absorption layer represented by the above PR4 is a CIGS absorption layer of a single phase. Moreover, the full width at half maximum height of the diffraction peak of the CIGS absorption layer represented by the above PR1-PR4 is gradually decreased, indicating that the internal grain size of the CIGS absorption layer is gradually increased.

The embodiments of the present disclosure further provide a preparation method of a solar cell, which comprises the preparation method of a solar absorption layer according to the above embodiment.

Compared with the related art, the preparation method of the solar cell provided in the embodiments of the present disclosure has the same beneficial effects as the preparation method of the solar absorption layer provided in the above embodiment, and it is not elaborated here.

It can be seen that, in the preparation method of a CIGS absorption layer and the preparation method of a solar cell provided in the embodiments of the present disclosure, parameters such as a carrier gas flow value, a first temperature threshold, a second temperature threshold, a first preset duration, a second preset duration, and a set pressure of the selenium atmosphere introduced above are controlled, such that the selenium element passes through the surface of the prefabricated copper indium gallium film, and the unsaturated In-Se binary phase and the unsaturated Cu-Se binary phase formed thereby are diffused toward the bottom of the prefabricated copper indium gallium film. This avoids the problem that element gallium is enriched at the bottom of the prepared CIGS absorption layer, thereby increasing the grain size of the CIGS absorption layer.

As shown in Fig. 5, some embodiments of the present disclosure also provide a CIGS absorption layer 100. The CIGS absorption layer 100 is prepared in the above preparation method of the CIGS absorption layer.

Compared with the related art, the CIGS absorption layer 100 provided in some embodiments of the present disclosure has the same beneficial effects as the preparation method of the CIGS absorption layer described above, and it is not elaborated here.

As shown in Fig. 5, some embodiments of the present disclosure also provide a solar cell 1. The solar cell 1 includes the above described CIGS absorption layer 100.

Compared with the related art, the solar absorption layer 1 provided in some embodiments of the present disclosure has the same beneficial effects as the preparation method of the CIGS absorption layer described above, and it is not elaborated here.

In some embodiments, as shown in Fig. 5, if not a back electrode 110 is deposited on the substrate 10 of the CIGS layer 100, then the solar cell 1 described above includes not only the CIGS absorption layer 100, but also the back electrode 110 and a front electrode 120. The CIGS layer 100 is located between the front electrode 110 and the back electrode 120.

In some embodiments, as shown in Fig. 5, if a back electrode 120 is deposited on the substrate 10 of the CIGS layer 100,the solar cell 1 described above includes the front electrode 120 in addition to the CIGS absorption layer 100. The front electrode 110 is located on a surface of the CIGS absorption layer 100 away from the back electrode 110.

The above embodiments illustrated with reference to the drawings describe in detail the structures, the features, the actions and the effects of the present disclosure. The above embodiments are merely preferred embodiments of the present disclosure, but the scope of the disclosure is not limited by the drawings of the present disclosure. Various changes and modifications can be made therein without departing from the scope of the invention/ method/apparatus as defined in the appended claims.

## Claims

1. A preparation method of a copper indium gallium selenide absorption layer (100), comprising:
forming a copper gallium alloy layer and an indium layer sequentially on a substrate (10) to obtain a prefabricated copper indium gallium film;
placing the prefabricated copper indium gallium film into a reaction chamber having a first preset temperature threshold, and introducing a selenium atmosphere having a first preset carrier gas flow value into the reaction chamber, wherein the prefabricated copper indium gallium film reacts in the selenium atmosphere having the first carrier gas flow value for a first preset duration, such that an unsaturated In-Se binary phase and an unsaturated Cu-Se binary phase are formed on a surface of the prefabricated copper indium gallium film;
introducing a selenium atmosphere having a second preset carrier gas flow value into the reaction chamber, wherein the prefabricated copper indium gallium film having an unsaturated In-Se binary phase and an unsaturated Cu-Se binary phase formed on a surface thereof reacts in a selenium atmosphere having the second carrier gas flow value for a second preset duration, such that a selenium source contained in the selenium atmosphere diffuses toward a bottom of the prefabricated copper indium gallium film, and reacts with the copper indium gallium contained in the prefabricated copper indium gallium film to obtain a copper indium gallium selenide prefabricated film formed on a surface of the substrate;
annealing the copper indium gallium selenide prefabricated film formed on the surface of the substrate (10) within a second preset temperature threshold and a third preset duration to obtain a copper indium gallium selenide absorption layer (100).

2. The preparation method of a copper indium gallium selenide absorption layer (100) according to claim 1, further comprises depositing a back electrode (120) on the substrate before the step of forming a copper gallium alloy layer and an indium layer; and
the step of forming a copper gallium alloy layer and an indium layer further comprises sequentially sputtering a copper gallium alloy layer and an indium layer on a surface of the back electrode (120) of the substrate (10), such that the back electrode (120), the copper gallium alloy layer and the indium layer are laminated together to obtain a prefabricated copper indium gallium film.

3. The preparation method of a copper indium gallium selenide absorption layer (100) according to claim 1, wherein a material of the prefabricated copper indium gallium film comprises Cu, In, and Ga, and a molar ratio of Cu, In, and Ga contained in the prefabricated copper indium gallium film satisfies: 0.8 < n_{Cu}/(n_{In}+n_{Ga}) < 0.96 and 0.25≤n_{Ga}/(n_{In}+n_{Ga})≤0.35, wherein n_{Cu} represents a mole number of Cu, n_{In} represents a mole number of In, and n_{Ga} represents a mole number of Ga .

4. The preparation method of a copper indium gallium selenide absorption layer (100) according to claim 3, wherein the second carrier gas flow value is less than the first carrier gas flow value, optionally, a ratio of the first carrier gas flow value to the second carrier gas flow value is greater than five, and optionally, the first carrier gas flow value is greater than or equal to 5 slm and less than or equal to 15 slm, and the second carrier gas flow value is greater than zero and less than or equal to 2 slm..

5. The preparation method of a copper indium gallium selenide absorption layer (100) according to claim 1, wherein before the step of placing the prefabricated copper indium gallium film into a reaction chamber having a first preset temperature threshold, and introducing a selenium atmosphere having a first preset carrier gas flow value into the reaction chamber,, the preparation method of the copper indium gallium selenide absorption layer (100) further comprises:
heating a solid selenium source to a temperature within a third preset temperature threshold in a vacuum or an inert gas with set pressure to obtain a selenium atmosphere.

6. The preparation method of a copper indium gallium selenide absorption layer (100) according to claim 5, wherein the first preset temperature threshold ranges from 550 °C to 580 °C, the second preset temperature threshold ranges from 500 °C to 600 °C, the third preset temperature threshold ranges 250 °C from 470 °C, and the set pressure ranges from 1 Pa to 1 atm, or
the first preset temperature threshold ranges from 620 °C to 700 °C, the second preset temperature threshold ranges from 500 °C to 600 °C, the third preset temperature threshold ranges from 380 °C to 500 °C, and the set pressure ranges from 1 Pa to 1 atm

7. The preparation method of a copper indium gallium selenide absorption layer (100) according to claim 6, wherein the first preset duration is 25 s to 35 s, the second preset duration is 260 s to 275 s, and the third preset duration is 5 min to 30 min, or the first preset duration is 15 s to 25 s, the second preset duration is 15 s to 35 s, and the third preset duration is 5 min to 30 min.

8. The preparation method of a copper indium gallium selenide absorption layer (100) according to claim 5, wherein the prefabricated copper indium gallium film in the step of placing the prefabricated copper indium gallium film into a reaction has an average temperature-rising rate greater than 3 °C/s in the reaction chamber.

9. The preparation method of a copper indium gallium selenide absorption layer (100) according to claim 1, wherein the selenium atmosphere comprises selenium vapor and/or hydrogen selenide gas.

10. The preparation method of a copper indium gallium selenide absorption layer (100) according to claim 4, wherein the annealing treatment is performed in a vacuum or in a selenium atmosphere having a third preset carrier gas flow value, and when the annealing process is performed in a selenium atmosphere having a third preset carrier gas flow value, the third preset carrier gas flow value is less than the second preset carrier gas flow value.

11. The preparation method of a copper indium gallium selenide absorption layer (100) according to claim 6, wherein the annealing treatment is performed in a vacuum or in a selenium atmosphere having a third preset carrier gas flow value; when the annealing process is performed in a selenium atmosphere having a third preset carrier gas flow value, the third preset carrier gas flow value is less than the second preset carrier gas flow value.

12. A preparation method of a solar cell (1), comprising the preparation method of a copper indium gallium selenide absorption layer (100) according to any of claims 1-11.

13. A copper indium gallium selenide absorption layer (100) prepared by the preparation method of the copper indium gallium selenide absorption layer (100) according to any of claims 1-11.

14. The copper indium gallium selenide absorption layer (100) according to claim 13, wherein a back electrode is deposited on the substrate;
the step of forming a copper gallium alloy layer and an indium layer sequentially on a substrate comprises: sequentially sputtering a copper gallium alloy layer and an indium layer on a surface of the back electrode of the substrate, such that the back electrode, the copper gallium alloy layer and the indium layer are laminated together to obtain a prefabricated copper indium gallium film.

15. A solar cell (1) comprising the copper indium gallium selenide absorption layer (100), wherein the copper indium gallium selenide absorption layer is prepared by the preparation method of the copper indium gallium selenide absorption layer according to any of claims 1-11.
